# EUROPEAN PATENT APPLICATION

(11) **EP 4 766 121 A1**
(43) Date of publication of application: **24.06.2026**
(21) Application number: 24855467.7
(22) Date of filing: 27.06.2024
(51) Int. Cl.: H10K 59/80

(54) **DISPLAY PANEL, DISPLAY DEVICE, AND MANUFACTURING METHOD FOR DISPLAY PANEL**

(30) Priority: 18.08.2023 CN 202311048928
(71) Applicant: Hefei Visionox Technology Co., Ltd., Hefei, Anhui 230000 (CN); Kunshan Go-Visionox Opto-Electronics Co., Ltd., KunShan, Jiangsu 215300 (CN)
(72) Inventor: LI, Yao, Hefei, Anhui 230000 (CN); ZHANG, Pengji, Hefei, Anhui 230000 (CN); FAN, Wenzhi, Hefei, Anhui 230000 (CN); MA, Qiteng, Hefei, Anhui 230000 (CN); JIN, Yu, Hefei, Anhui 230000 (CN); CHEN, Fei, Hefei, Anhui 230000 (CN)
(74) Representative: Kraus & Lederer PartGmbB
(86) International application number: PCT/CN2024/101865
(87) International publication number: WO 2025/039738

(57) **Abstract**

The present application provides a display panel, comprising: a substrate; a functional layer, the functional layer comprising a body portion and grooves formed by recessing the surface of the body portion facing away from the substrate; and an insulating layer located on the side of the functional layer facing away from the substrate, the insulating layer comprising a first sub-layer and a second sub-layer which are stacked, the refractive index of the first sub-layer being less than that of the second sub-layer, the second sub-layer comprising through clearance holes, and the orthographic projections of the grooves on the substrate being located within the orthographic projections of the clearance holes on the substrate.

## Description

### CROSS-REFERENCE TO RELATED APPLICATIONS

The present application claims the priority to Chinese Patent Application No. 202311048928.2 filed on August 18, 2023, and titled "DISPLAY PANEL, DISPLAY APPARATUS, AND MANUFACTURING METHOD FOR DISPLAY PANEL", which is incorporated herein by reference in its entirety.

### TECHNICAL FIELD

The present application relates to the technical field of display devices, and in particular to a display panel, a display apparatus, and a manufacturing method for a display panel.

### BACKGROUND

The planar display apparatuses based on the organic light-emitting diode (OLED), the light-emitting diode (LED), among others are widely used in cell phones, TVs, notebook computers, desktop computers and other consumer electronic products due to their advantages such as high image quality, power saving, thin body, and wide range of applications, and have become the mainstream among the display apparatuses.

However, the process performance of current OLED display products needs to be improved.

### SUMMARY

The embodiments of the present application provide a display panel, a display apparatus, and a manufacturing method for a display panel to improve the process performance of the display panel.

The embodiments in a first aspect of the present application provide a display panel, which comprises a substrate; a functional layer, located on one side of the substrate, the functional layer comprising a body portion and a groove formed by a recess in a surface of the body portion away from the substrate; and an insulating layer, located on one side of the functional layer away from the substrate, the insulating layer comprising a first sub-layer and a second sub-layer which are stacked, a refractive index of the first sub-layer being less than a refractive index of the second sub-layer, the second sub-layer comprising a first hole penetrating therethrough, and an orthographic projection of the groove on the substrate being located within an orthographic projection of the first hole on the substrate.

The embodiments in a second aspect of the present application further provide a display apparatus which comprises the display panel according to any one of the embodiments in the first aspect.

The embodiments in a third aspect of the present application further provide a manufacturing method for a display panel, and the method comprises:
providing a functional layer on a substrate;
patterning the functional layer to form a body portion and a groove formed by a recess in a surface of the body portion away from the substrate; and
providing an insulating layer on one side of the functional layer away from the substrate, the insulating layer comprising a first sub-layer and a second sub-layer which are stacked in a direction away from the functional layer, a refractive index of the first sub-layer being less than a refractive index of the second sub-layer, the second sub-layer comprising a first hole penetrating therethrough, and an orthographic projection of the groove on the substrate being located within an orthographic projection of the first hole on the substrate.

In the display panel provided in the embodiments of the present application, the display panel comprises the substrate, the functional layer, and the insulating layer, and the functional layer comprises the body portion and the groove. Since the groove is formed by a recess in a surface of the body portion, a step difference is formed between the groove and the body portion. The insulating layer comprises the first sub-layer and the second sub-layer, and the refractive index of the second sub-layer is higher than that of the first sub-layer. The second sub-layer is doped with relatively more particles with a high refractive index such that the curing shrinkage of the second sub-layer is relatively high. In the present application, by providing the first hole in the second sub-layer, the second sub-layer is arranged to avoid a position of the groove to prevent an influence of the second sub-layer on the structural layers in the groove and improve the process performance of the display panel.

### BRIEF DESCRIPTION OF THE DRAWINGS

Other features, objects, and advantages of the present application will become more apparent from the following detailed description of non-limiting embodiments with reference to the drawings, in which same or similar reference numerals indicate same or similar features.
Fig. 1 shows a schematic structural view of a display panel according to an embodiment of the present application;
Fig. 2 shows a partial enlarged schematic structural view at I in Fig. 1;
Fig. 3 shows a partial cross-sectional view of Fig. 2 in one example;
Fig. 4 shows a partial cross-sectional view of Fig. 2 in another example;
Fig. 5 shows a partial cross-sectional view of Fig. 2 in yet another example;
Fig. 6 shows a partial cross-sectional view of Fig. 2 in still another example;
Fig. 7 shows a partial enlarged schematic structural view at II in Fig. 1;
Fig. 8 shows a partial cross-sectional view of Fig. 7; and
Fig. 9 shows a flow chart for manufacturing a display panel according to an embodiment of the present application.

### DETAILED DESCRIPTION

Features of various aspects and exemplary embodiments of the present application will be described in detail below. In the following detailed description, numerous specific details are presented to provide a thorough understanding of the present application. However, it will be apparent for those skilled in the art that, the present application may be implemented without some of these specific details. The following description of the embodiments is merely to provide a better understanding of the present application by illustrating examples. In the drawings and the following description, at least a part of the well-known structures and techniques are not shown to avoid unnecessarily obscuring the present application. In addition, the dimensions of some of the structures may be enlarged for clarity. Furthermore, the features, structures, or characteristics described below may be combined in one or more embodiments in any suitable manner.

In the description of the present application, it should be noted that, unless otherwise specified, "a plurality of" or "multiple" means at least two. The orientation or position relationships indicted by the terms "upper", "lower", "left", "right", "inner", "outer", among others are only used for facilitating the description of the present application and simplifying the description. It does not indicate or imply that the apparatus or element referred to must have a specific orientation, be constructed and operated in a specific orientation, and therefore cannot be understood as a limitation on the present application. Moreover, the terms "first", "second", among others are only used for descriptive purposes and cannot be understood as indicating or implying relative importance.

The direction words appearing in the following description are directions shown in the drawings, and are not intended to limit the specific structure of the embodiments in the present application. It should also be noted that, in the description of the present application, unless otherwise clearly specified and limited, the terms "installation" and "connection" should be understood in a broad sense. For example, it may be a fixed connection, or a detachable connection, or formed as an integral body; it may be a direct connection or an indirect connection. For those skilled in the art, the specific meanings of the above terms in the present application may be understood according to specific situations.

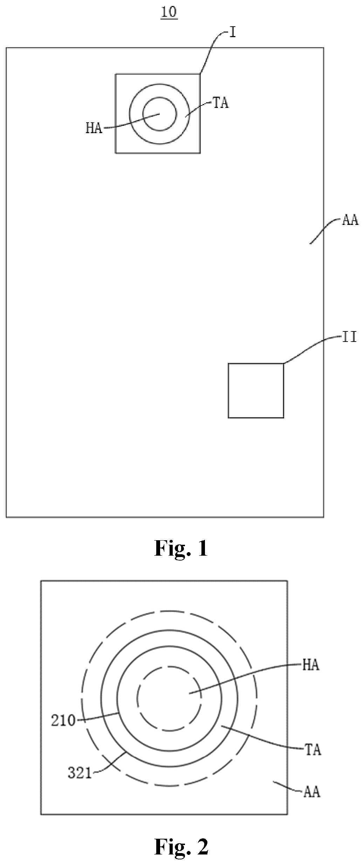

In order to better understand the present application, a display panel 10, a display apparatus, and a manufacturing method for a display panel 10 according to the embodiments of the present application will be described in detail below with reference to Figs. 1 to 9.

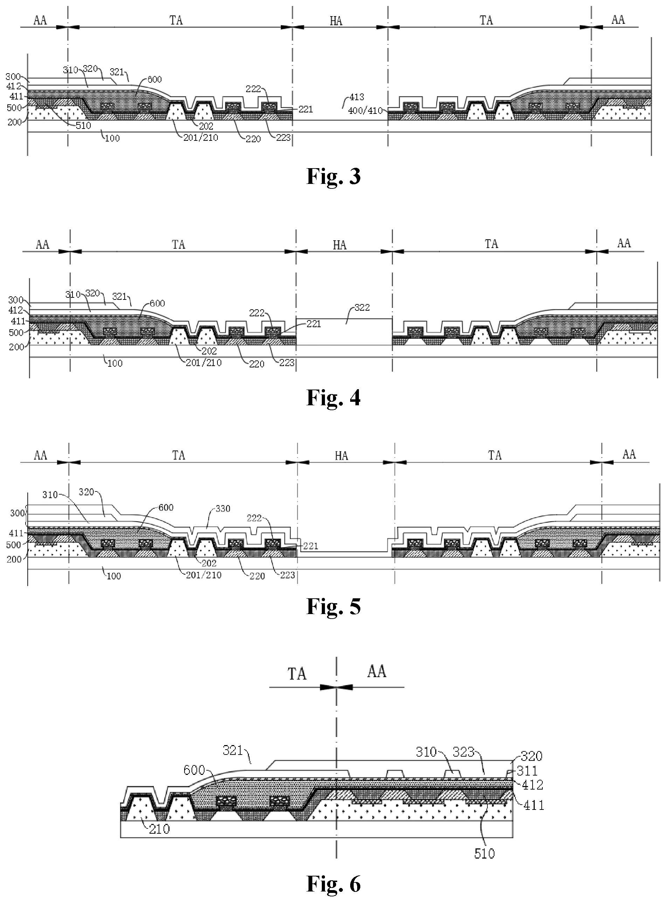

Fig. 1 shows a schematic structural view of a display panel 10 according to an embodiment of the present application; Fig. 2 shows a partial enlarged schematic structural view at I in Fig. 1; Fig. 3 shows a partial cross-sectional view of Fig. 2.

As shown in Figs. 1 to 3, the display panel 10 provided in the present application comprises a substrate 100, a functional layer 200, and an insulating layer 300. The functional layer 200 is located on one side of the substrate 100. The functional layer 200 comprises a body portion 201 and a groove 202 formed by a recess in a surface of the body portion 201 away from the substrate 100. The insulating layer 300 is located on one side of the functional layer 200 away from the substrate 100, and the insulating layer 300 comprises a first sub-layer 310 and a second sub-layer 320 which are stacked. A refractive index of the first sub-layer 310 is less than a refractive index of the second sub-layer 320. The second sub-layer 320 comprises a first hole 321 penetrating therethrough, and an orthographic projection of the groove 202 on the substrate 100 is located within an orthographic projection of the first hole 321 on the substrate 100.

Optionally, the first sub-layer 310 may be located on one side of the second sub-layer 320 facing the substrate 100, or the first sub-layer 310 may be located on one side of the second sub-layer 320 away from the substrate 100.

In the display panel 10 provided in the embodiments of the present application, the display panel 10 comprises the substrate 100, the functional layer 200, and the insulating layer 300, and the functional layer 200 comprises the body portion 201 and the groove 202. Since the groove 202 is formed by a recess in a surface of the body portion 201, a step difference is formed between the groove 202 and the body portion 201. The insulating layer 300 comprises the first sub-layer 310 and the second sub-layer 320, and the refractive index of the second sub-layer 320 is higher than that of the first sub-layer 310. The second sub-layer 320 is doped with relatively more particles with a high refractive index such that the curing shrinkage of the second sub-layer 320 is relatively high. In the present application, by providing the first hole 321 in the second sub-layer 320, the second sub-layer 320 is arranged to avoid a position of the groove 202, thereby mitigating an influence of the second sub-layer 320 on the structural layers in the groove 202 and improving the process performance of the display panel 10.

There are multiple ways for providing the substrate 100. The substrate 100 may comprise a baseplate as well as a first conductive layer, a second conductive layer, and a third conductive layer which are stacked on one side of the baseplate, and an insulating layer is provided between adjacent conductive layers. Exemplarily, the substrate 100 may comprise a pixel driving circuit, and in particular, the pixel driving circuit comprises a transistor and a storage capacitor. The transistor comprises a semiconductor, a gate, a source, and a drain. The storage capacitor comprises a first electrode plate and a second electrode plate. As an example, the gate and the first electrode plate may be located in the first conductive layer, the second electrode plate may be located in the second conductive layer, and the source and the drain may be located in the third conductive layer.

There are multiple ways for providing the functional layer 200, as long as the groove 202 is provided in the functional layer 200 to form the step difference. The step difference refers to a height difference. For example, the groove 202 is a blind groove, and a difference between a distance from a surface of the body portion 201 away from the substrate 100 to the substrate 100 and a distance from a bottom surface of the groove 202 to the substrate 100 is the step difference. Alternatively, the groove 202 is a through groove, that is, the groove 202 penetrates through the body portion 201, and a thickness of the body portion 201 is the step difference.

There are multiple ways for providing the insulating layer 300. For example, the insulating layer 300 may be an optical functional layer, in which the first sub-layer 310 is a low-refractive-index optical adhesive layer, and the second sub-layer 320 is a high-refractive-index optical adhesive layer. A light extraction efficiency of the display panel 10 is improved by the first sub-layer 310 and the second sub-layer 320. For example, the first sub-layer 310 is formed by doping inorganic particles with a low refractive index in an organic material or not doping inorganic particles, and the second sub-layer 320 is formed by doping relatively more inorganic particles with a high refractive index in an organic material. The inorganic particles with a high refractive index cause the second sub-layer 320 to have a relatively large curing shrinkage and a relatively large deformation before and after curing.

Optionally, an area of an orthographic projection of the groove 202 on the substrate 100 is less than an area of an orthographic projection of the first hole 321 on the substrate 100. For example, the orthographic projection of the groove 202 on the substrate 100 is located within the orthographic projection of the first hole 321 on the substrate 100, and an edge of the orthographic projection of the groove 202 on the substrate 100 is spaced from an edge of the orthographic projection of the first hole 321 on the substrate 100, such that a position with the step difference is not covered by the second sub-layer 320 to better prevent the influence of the second sub-layer 320 on the structural layers in the groove 202 and solve the problem of easy fracture of the structural layers.

There are multiple ways for providing the structural layers. In some optional embodiments, the display panel 10 further comprises an inorganic layer 400 located on one side of the insulating layer 300 facing the substrate 100, and the orthographic projection of the groove 202 on the substrate 100 is located within an orthographic projection of the inorganic layer 400 on the substrate 100.

In these optional embodiments, the inorganic layer 400 is provided between the insulating layer 300 and the substrate 100, and the orthographic projection of the groove 202 on the substrate 100 is located within the orthographic projection of the inorganic layer 400 on the substrate 100, that is, the inorganic layer 400 exists in an area of the step difference. The inorganic layer 400 is prone to fracture under stress. By providing the first hole 321 in the second sub-layer 320, the fracture susceptibility of the inorganic layer 400 can be mitigated.

The functional layer 200 can be positioned in various ways. For example, the functional layer 200 is located between the inorganic layer 400 and the insulating layer 300, and/or the functional layer 200 is located on one side of the inorganic layer 400 away from the insulating layer 300.

The inorganic layer 400 may comprise an inorganic encapsulation layer 410. Thus, since the second sub-layer 320 is provided with the first hole 321, its influence on the inorganic encapsulation layer 410 may be mitigated to ensure an encapsulation effect of the display panel 10. One or more inorganic encapsulation layers 410 may be provided, and at least two inorganic encapsulation layers 410 can improve the encapsulation effect of the display panel 10.

Optionally, the display panel 10 further comprises a light-emitting layer 500, and the inorganic encapsulation layer 410 is configured to encapsulate the light-emitting layer 500 so as to prevent an influence of water and oxygen intrusion on a light-emitting material of the light-emitting layer 500. The light-emitting layer 500 comprises a light-emitting unit 510.

In some optional embodiments, the functional layer 200 is located on one side of the inorganic layer 400 away from the insulating layer 300. For example, the inorganic layer 400 is the inorganic encapsulation layer 410, and the inorganic encapsulation layer 410 is located on one side of the functional layer 200 away from the substrate 100. Thus, the inorganic encapsulation layer 410 can protect the functional layer 200 and prevent water and oxygen intrusion. The second sub-layer 320 is provided with the first hole 321, which can reduce the force applied to the inorganic encapsulation layer 410 during thermal shrinkage and expansion thereof, prevent the fracture of the inorganic encapsulation layer 410, and thus prevent the water and oxygen intrusion caused by the fracture of the inorganic encapsulation layer 410.

In some optional embodiments, the display panel 10 comprises a first area HA, a second area AA surrounding at least a part of the first area HA, and a transition area TA located between the first area HA and the second area AA, the body portion 201 comprises a first barrier wall 210 located in the transition area TA and surrounding the first area HA, and an orthographic projection of the first barrier wall 210 on the substrate 100 is located within the orthographic projection of the first hole 321 on the substrate 100.

In these optional embodiments, a relatively large step difference is formed between two sides of the first barrier wall 210 located in the transition area TA, and the first barrier wall 210 may enclose to form the aforementioned groove 202. Under a condition that the orthographic projection of the first barrier wall 210 on the substrate 100 is located within the orthographic projection of the first hole 321 on the substrate 100, a material of the second sub-layer 320 may not extend to the first barrier wall 210 and one side of the first barrier wall 210 facing the first area HA, which can reduce the force applied to the inorganic encapsulation layer 410 on the first barrier wall 210 during the thermal shrinkage curing of the second sub-layer 320, thereby reducing the fracture probability of the inorganic encapsulation layer 410 near the first barrier wall 210.

There are multiple ways for providing the first area HA. Optionally, the first area HA may be an aperture area of the display panel 10. When the display panel 10 is used in a display apparatus, a photosensitive element of the display apparatus, such as a camera among others, may be located on a non-display side of the first area HA such that the photosensitive element may obtain optical information through the first area HA. Optionally, the second area AA is an active area, and the second area AA is provided with a plurality of sub-pixels to achieve the light-emitting display of the display panel 10.

In some optional embodiments, the body portion 201 further comprises isolation portions 220 located on one side of the first barrier wall 210 facing the first area HA, the isolation portions 220 are arranged surrounding the first area HA, and at least two isolation portions 220 are provided; the groove 202 is formed between at least two adjacent isolation portions 220, and/or the groove 202 is formed between the first barrier wall 210 and an isolation portion 220.

In these optional embodiments, the isolation portions 220 are provided on one side of the first barrier wall 210 facing the first area HA. By providing the isolation portions 220, a common electrode, a light-emitting material, among others can be disconnected at the isolation portions 220 to prevent water, oxygen among others from extending along the structural layers such as a common electrode towards the second area AA. At least two isolation portions 220 are provided to better prevent the water and oxygen intrusion. Since the isolation portions 220 have a certain height, the groove 202 is formed between the adjacent isolation portions 220 or between the isolation portion 220 and the first barrier wall 210. In the present application, by providing the first hole 321 in the second sub-layer 320, the inorganic encapsulation layer 410 in the area where the groove 202 is located is less susceptible to fracture by the influence of the second sub-layer 320.

Optionally, there are multiple ways for providing the number of the first barrier walls 210, and one or more first barrier walls 210 may be provided. When at least two first barrier walls 210 are provided, the aforementioned groove 202 may also be formed between at least two adjacent first barrier walls 210.

There are multiple ways for providing the isolation portion 220. The isolation portion 220 may comprise a first sub-portion 221 and a second sub-portion 222 which are stacked in a direction away from the substrate 100, and an orthographic projection of the first sub-portion 221 on the substrate 100 is located within an orthographic projection of the second sub-portion 222 on the substrate 100. Under this condition, a recess is easily formed under the second sub-portion 222, and the structural layers, such as the light-emitting material and the common electrode, among others, are susceptible to fracture at a position where the isolation portion 220 is located. Optionally, the isolation portion 220 further comprises a third sub-portion 223 located on one side of the first sub-portion 221 away from the second sub-portion 222, and the orthographic projection of the first sub-portion 221 on the substrate 100 is located within an orthographic projection of the third sub-portion 223 on the substrate 100. The third sub-portion 223 can provide protection for the structural layers below the isolation portion 220.

Optionally, the isolation portion 220 is in the form of a closed loop and is arranged surrounding the first area HA. Optionally, a plurality of isolation portions 220 are nested within each other.

Optionally, as described above, at least two inorganic encapsulation layers 410 are provided, which comprise a first inorganic encapsulation layer 411 and a second inorganic encapsulation layer 412. Optionally, an organic encapsulation layer 600 is provided between the first inorganic encapsulation layer 411 and the second inorganic encapsulation layer 412, and the organic encapsulation layer 600 is located on one side of the first barrier wall 210 facing the second area AA. A thickness of the organic encapsulation layer 600 is relatively large, and the organic encapsulation layer 600 is isolated in the second area AA by the first barrier wall 210 to ensure the flatness of the second area AA.

Optionally, on one side of the first barrier wall 210 facing the first area HA, the first inorganic encapsulation layer 411 and the second inorganic encapsulation layer 412 are connected in a contact manner.

Optionally, the inorganic encapsulation layer 410 comprises a via 413 located in the first area HA to improve the light transmittance of the first area HA. Optionally, the first inorganic encapsulation layer 411 and the second inorganic encapsulation layer 412 each comprise the via 413.

In some optional embodiments, as shown in Fig. 4, the second sub-layer 320 further comprises a clearance portion 322 located within the first hole 321, and an orthographic projection of the clearance portion 322 on the substrate 100 is located within the first area HA. In these optional embodiments, since the first barrier wall 210 and/or the isolation portion 220 do not exist in the first area HA, a material of the second sub-layer 320 may be retained at a position of the first area HA to form the clearance portion 322, thus making a surface of the insulating layer 300 flatter.

There are multiple ways for providing the clearance portion 322. As described above, the clearance portion 322 may be formed by a material retained in the first area HA when the material of the second sub-layer 320 is patterned, that is, the material of the clearance portion 322 is the same as that of the second sub-layer 320. Alternatively, the clearance portion 322 may be additionally manufactured within the first hole 321 after the second sub-layer 320 is manufactured. For example, when the insulating layer 300 is provided with a polarizer among others, the clearance portion 322 may be formed from an adhesive layer of the polarizer facing the insulating layer 300.

In some other optional embodiments, as shown in Fig. 5, a third sub-layer 330 is further provided on one side of the second sub-layer 320 away from the first sub-layer 310, a refractive index of the third sub-layer 330 is less than the refractive index of the second sub-layer 320, and at least a part of the third sub-layer 330 fills the first hole 321.

In these optional embodiments, a continuous third sub-layer 330 is provided on an entire surface of the second sub-layer 320. The third sub-layer 330 has a relatively low refractive index and a relatively low expansion and contraction rate, and thus the third sub-layer 330 will not easily affect the aforesaid inorganic layer 400. Moreover, the third sub-layer 330 can fill at least a part of the first hole 321, whereby the flatness of a surface of the insulating layer 300 can be improved.

Optionally, a material of the third sub-layer 330 may be the same as a material of the first sub-layer 310 to simplify the manufacturing of the display panel 10.

Optionally, in any one of the above embodiments, as shown in Fig. 6, the first sub-layer 310 comprises a concave portion 311 located in the active area, that is, the concave portion 311 is located in the second area AA, and the second sub-layer 320 further comprises a convex portion 323 located within the concave portion 311. An orthographic projection of the concave portion 311 on the substrate 100 at least partially overlaps with an orthographic projection of the light-emitting unit 510 on the substrate 100, such that the large-angle light emitted by the light-emitting unit 510 can transmit through a contact interface between the concave portion 311 and the convex portion 323 to change the light-emitting path of the light-emitting unit 510 and improve a light extraction efficiency of the light-emitting unit 510. Optionally, the concave portion 311 penetrates through the first sub-layer 310.

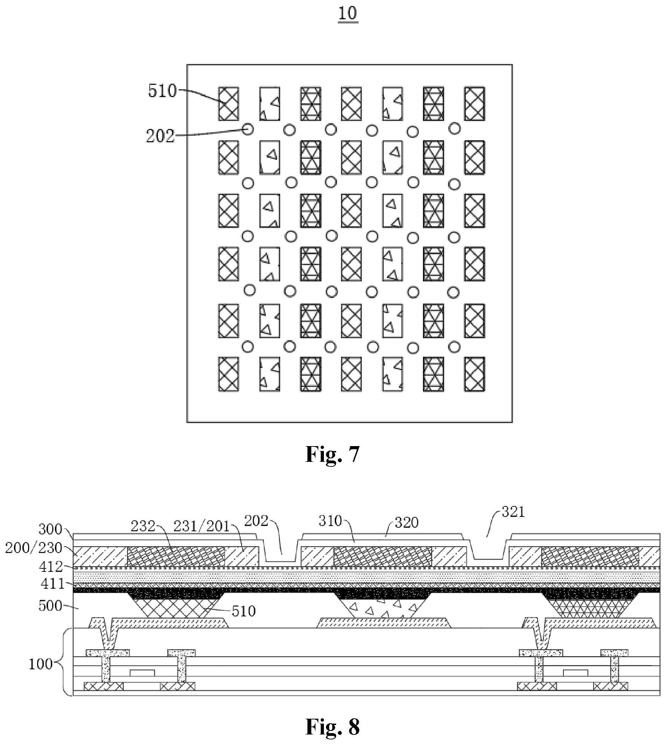

In other embodiments, as shown in Figs. 7 and 8, the functional layer 200 is located between the inorganic layer 400 and the insulating layer 300, the functional layer 200 comprises a filter layer 230, the filter layer 230 comprises a light-shielding portion 231, a filter opening enclosed by the light-shielding portion 231, and a filter unit 232 located in the filter opening, the body portion 201 comprises the light-shielding portion 231, and the groove 202 is formed by a recess in a surface of the light-shielding portion 231 away from the substrate 100.

In these optional embodiments, the functional layer 200 is located on one side of the inorganic layer 400 away from the substrate 100, and the functional layer 200 comprises the filter layer 230, in which the light-shielding portion 231 of the filter layer 230 is provided with not only the opening for accommodating the filter unit 232, but also the groove 202. The groove 202 can improve the light transmittance of the filter layer 230, but the groove 202 is not filled with other materials, which results in the step difference at a position thereof. By providing the first hole 321 in the second sub-layer 320, an acting force on the inorganic layer 400 brought about by the second sub-layer 320 during the curing and shrinking process due to the step difference can be reduced to prevent the fracture of the inorganic layer 400.

Optionally, the display panel 10 comprises an active area, and the groove 202 and the first hole 321 are both located in the active area to improve the light transmittance of the active area. Optionally, the active area comprises a photosensitive aperture active area. When the display panel is used in a display apparatus, the display apparatus comprises a photosensitive element, in which the photosensitive element is provided on a back side of the photosensitive aperture active area, and the groove 202 and the first hole 321 are both located in the photosensitive aperture active area to improve the light transmittance of the photosensitive aperture active area and facilitate the photosensitive element to obtain the optical information. Optionally, the groove 202 penetrates through the light-shielding portion 231 to further improve the light transmittance.

Optionally, the second area AA is the active area. In one display panel 10, the display panel 10 comprises the first area HA, the second area AA, and the transition area TA, and two types of first holes 321 may be provided, wherein one type of the first hole 321 is provided corresponding to the groove 202 between the first barrier wall 210 and the isolation portion 220, or the groove 202 between adjacent isolation portions 220, or the groove 202 between adjacent first barrier walls 210 in the transition area TA, and the other type of the first hole 321 is provided corresponding to the groove 202 in the light-shielding portion 231 in the second area AA (that is, the active area).

In other embodiments, only one type of first hole 321 may be provided, wherein the first hole 321 is provided corresponding to the groove 202 between the first barrier wall 210 and the isolation portion 220, or the groove 202 between adjacent isolation portions 220, or the groove 202 between adjacent first barrier walls 210 in the transition area TA; or the first hole 321 is provided corresponding to the groove 202 in the light-shielding portion 231 in the second area AA (that is, the active area).

In any one of the above embodiments, optionally, the display panel 10 further comprises a non-active area surrounding at least a part of the active area (that is, the second area AA), the non-active area is provided with a second barrier wall, and an edge of an orthographic projection of the second sub-layer 320 on the substrate 100 is located on one side of an orthographic projection of the second barrier wall on the substrate 100 facing the active area. The organic encapsulation layer is typically provided on one side of the second barrier wall facing the active area, and the step difference exists on one side of the second barrier wall away from the active area, the edge of the second sub-layer 320 is located on one side of the second barrier wall facing the active area, which can mitigate the influence of the second sub-layer 320 on the structural layers at the position of the step difference, and improve the process performance of the display panel 10.

In any one of the above embodiments, the groove 202 may be a through groove or a blind groove. Optionally, the groove 202 is the through groove. For example, the groove 202 is formed by adjacent isolation portions 220 that are spaced from each other, or the groove 202 is formed by adjacent first barrier wall 210 and isolation portion 220 that are spaced from each other, and there is no other structural layer filling a space between the adjacent isolation portions 220 or between the adjacent isolation portion 220 and the first barrier wall 210, and thus the structural layers, such as the common electrode among others, are more susceptible to fracture here. Optionally, for example, the groove 202 penetrates through the light-shielding portion 231 to improve the light transmittance of the functional layer 200.

The embodiments in a second aspect of the present application further provide a display apparatus which comprises the display panel 10 according to any one of the embodiments in the first aspect. Since the display apparatus according to the second aspect of the present application comprises the display panel 10 according to any one of the embodiments in the first aspect, the display apparatus according to the second aspect of the present application has the beneficial effects of the display panel 10 according to any one of the embodiments in the first aspect, which will not be described in detail here.

The display apparatus in the embodiments of the present application comprises, but is not limited to, mobile phone, personal digital assistant (PDA), tablet computer, electronic book, television, access control, smart fixed telephone, console and other devices with display function.

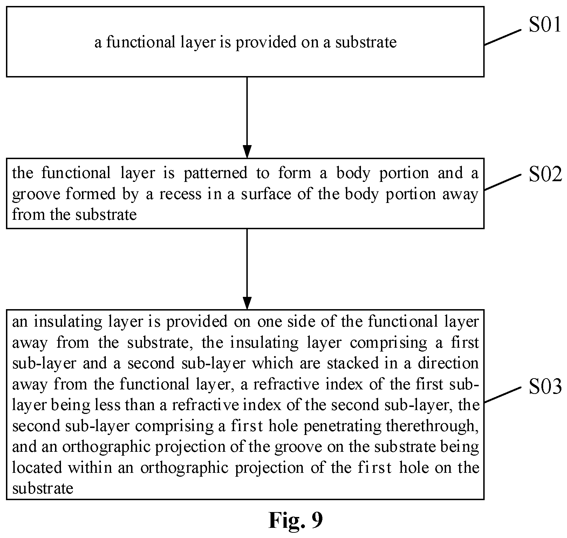

As shown in Fig. 9, the embodiments in a third aspect of the present application further provide a manufacturing method for a display panel 10, which may be the display panel 10 according to any one of the embodiments in the first aspect. Refer to Figs. 1 to 9 together, the manufacturing method for the display panel 10 comprises Step S01, Step S02 and Step S03.

In Step S01: a functional layer 200 is provided on a substrate 100.

In Step S02: the functional layer 200 is patterned to form a body portion 201 and a groove 202 formed by a recess in a surface of the body portion 201 away from the substrate 100.

Optionally, when the body portion 201 comprises a first barrier wall 210, a groove 202 between two adjacent first barrier walls 210 is formed by a pattern processing. Optionally, when the body portion 201 comprises a first barrier wall 210 and an isolation portion 220, and the isolation portion 220 comprises a first sub-portion 221, a second sub-portion 222, and a third sub-portion 223, the film layers where the first sub-portion 221, the second sub-portion 222, and the third sub-portion 223 are located may be patterned in sequence to form the isolation portion 220 and a groove 202 between adjacent first barrier wall 210 and isolation portion 220 and/or between adjacent isolation portions 220.

In Step S03: an insulating layer 300 is provided on one side of the functional layer 200 away from the substrate 100, the insulating layer 300 comprising a first sub-layer 310 and a second sub-layer 320 which are stacked in a direction away from the functional layer 200, a refractive index of the first sub-layer 310 being less than a refractive index of the second sub-layer 320, the second sub-layer 320 comprising a first hole 321 penetrating therethrough, and an orthographic projection of the groove 202 on the substrate 100 being located within an orthographic projection of the first hole 321 on the substrate 100.

In the display panel 10 manufactured in the embodiments of the present application, the display panel 10 comprises the substrate 100, the functional layer 200, and the insulating layer 300, and the functional layer 200 comprises the body portion 201 and the groove 202. Since the groove 202 is formed by a recess in a surface of the body portion 201, a step difference is formed between the groove 202 and the body portion 201. The insulating layer 300 comprises the first sub-layer 310 and the second sub-layer 320, and the refractive index of the second sub-layer 320 is higher than that of the first sub-layer 310. The second sub-layer 320 is doped with relatively more particles with a high refractive index such that the curing shrinkage of the second sub-layer 320 is relatively high. In the present application, by providing the first hole 321 in the second sub-layer 320, the second sub-layer 320 is arranged to avoid a position of the groove 202 to prevent an influence of the second sub-layer 320 on the structural layers in the groove 202 and improve the process performance of the display panel 10.

Although the present application has been described with reference to preferred embodiments, various modifications may be performed and the elements thereof may be replaced by equivalents without departing from the scope of the present application. In particular, as long as there is no structural conflict, the technical features mentioned in each embodiment can be combined in any manner. The present application is not limited to the particular embodiments disclosed herein, but includes all technical solutions falling within the scope of the claims.

## Claims

1. A display panel, comprising a substrate, a functional layer and an insulating layer, **characterized in that** the functional layer is located on a side of the substrate, the functional layer comprising a body portion and a groove formed by a recess in a surface of the body portion away from the substrate; and
the insulating layer is located on a side of the functional layer away from the substrate, the insulating layer comprising a first sub-layer and a second sub-layer which are stacked, a refractive index of the first sub-layer being less than a refractive index of the second sub-layer, the second sub-layer comprising a first hole penetrating therethrough, and an orthographic projection of the groove on the substrate being located within an orthographic projection of the first hole on the substrate.

2. The display panel according to claim 1, further comprising an inorganic layer located on a side of the insulating layer facing the substrate, the orthographic projection of the groove on the substrate being located within an orthographic projection of the inorganic layer on the substrate.

3. The display panel according to claim 2, wherein the functional layer is located between the inorganic layer and the insulating layer, and/or the functional layer is located on a side of the inorganic layer away from the insulating layer.

4. The display panel according to claim 3, wherein the inorganic layer comprises an inorganic encapsulation layer.

5. The display panel according to claim 3, wherein the inorganic layer comprises at least two inorganic encapsulation layers.

6. The display panel according to claim 3, wherein the functional layer is located on the side of the inorganic layer away from the insulating layer,
the display panel comprises a first area, a second area surrounding at least a part of the first area, and a transition area located between the first area and the second area, the body portion comprises at least one first barrier wall located in the transition area and surrounding the first area, and an orthographic projection of the at least one first barrier wall on the substrate is located within the orthographic projection of the first hole on the substrate.

7. The display panel according to claim 6, wherein the at least one first barrier wall comprises at least two of the first barrier walls.

8. The display panel according to claim 6, wherein the body portion further comprises at least two isolation portions located on a side of the at least one first barrier wall facing the first area and arranged surrounding the first area, and
the groove is formed between at least adjacent two of the isolation portions, and/or the groove is formed between the at least one first barrier wall and one of the isolation portions, and/or the groove is formed between at least adjacent two of the first barrier walls.

9. The display panel according to claim 6, wherein the inorganic layer comprises a via located in the first area.

10. The display panel according to claim 6, wherein the first area is an aperture area and the second area is an active area.

11. The display panel according to claim 6, wherein the second sub-layer further comprises a clearance portion located within the first hole, and an orthographic projection of the clearance portion on the substrate is located within the first area.

12. The display panel according to claim 6, wherein the insulating layer further comprises a third sub-layer provided on a side of the second sub-layer away from the first sub-layer, a refractive index of the third sub-layer is less than the refractive index of the second sub-layer, and at least a part of the third sub-layer fills the first hole.

13. The display panel according to claim 3, wherein the functional layer is located between the inorganic layer and the insulating layer and comprises a filter layer,
the filter layer comprises a light-shielding portion, a filter opening enclosed by the light-shielding portion, and a filter unit located in the filter opening,
the body portion comprises the light-shielding portion, and the groove is formed by a recess in a surface of the light-shielding portion away from the substrate.

14. The display panel according to claim 13, wherein the display panel comprises an active area, wherein the groove and the first hole are both located in the active area.

15. The display panel according to claim 14, wherein the active area comprises a photosensitive aperture active area, and the groove and the first hole are both located in the photosensitive aperture active area.

16. The display panel according to claim 1, comprising an active area and a non-active area surrounding at least a part of the active area, wherein the non-active area is provided with a second barrier wall, and an edge of an orthographic projection of the second sub-layer on the substrate is located on a side of an orthographic projection of the second barrier wall on the substrate facing the active area.

17. The display panel according to claim 1, wherein the groove penetrates through the body portion.

18. The display panel according to claim 1, wherein the first sub-layer is located on a side of the second sub-layer facing the substrate.

19. A display apparatus, comprising the display panel according to claim 1.

20. A manufacturing method for a display panel, comprising:
providing a functional layer on a substrate;
patterning the functional layer to form a body portion and a groove formed by a recess in a surface of the body portion away from the substrate; and
providing an insulating layer on a side of the functional layer away from the substrate, the insulating layer comprising a first sub-layer and a second sub-layer which are stacked in a direction away from the functional layer, a refractive index of the first sub-layer being less than a refractive index of the second sub-layer, the second sub-layer comprising a first hole penetrating therethrough, and an orthographic projection of the groove on the substrate being located within an orthographic projection of the first hole on the substrate.
